# EUROPEAN PATENT APPLICATION

(11) **EP 2 717 332 A1**
(43) Date of publication of application: **09.04.2014**
(21) Application number: 12793109.5
(22) Date of filing: 24.05.2012
(51) Int. Cl.: H01L 31/18, H01L 31/0224, H01L 31/0747

(54) **METHOD FOR PRODUCING SOLAR CELL**

(30) Priority: 03.06.2011 JP 2011124937
(71) Applicant: Sanyo Electric Co., Ltd., Osaka 570-8677 (JP)
(72) Inventor: SHIMA, Masaki, Moriguchi City Osaka 570-8677 (JP); MATSUBARA, Yoshihiro, Moriguchi City Osaka 570-8677 (JP)
(74) Representative: Glawe, Delfs, Moll
(86) International application number: PCT/JP2012/063313
(87) International publication number: WO 2012/165289

(57) **Abstract**

A manufacturing method for a solar cell having improved output characteristics is provided. After forming a p-side transparent conductive oxide layer (15), an n-side transparent conductive oxide layer (16) is formed.

## Description

### FIELD OF THE INVENTION

The present invention relates to a manufacturing method for a solar cell.

### BACKGROUND OF THE INVENTION

Interest in solar cells has increased in recent years as an energy source with a low environmental impact. A solar cell is disclosed in Patent Document 1 which has a photoelectric conversion unit, a transparent conductive oxide (TCO) layer arranged on the photoelectric conversion unit, a p-side electrode, and an n-side electrode.

### Prior Art Documents

### Patent Documents

Patent Document 1: Laid-Open Patent Publication No. 2004-289058

### SUMMARY OF THE INVENTION

### Problem Solved by the Invention

In recent years, there has been growing demand for solar cells having improved output characteristics.

In view of this situation, it is an object of the present invention to provide a manufacturing method for a solar cell having improved output characteristics.

### Means of Solving the Problem

The present invention relates to a manufacturing method for a solar cell provided with a photoelectric conversion unit having a p-type surface and an n-type surface, a p-side transparent conductive oxide layer arranged on the p-type surface, an n-side transparent conductive oxide layer arranged on the n-type surface, a p-side electrode arranged on the p-side transparent conductive oxide layer, and an n-side electrode arranged on the n-side transparent conductive oxide layer. In the manufacturing method for a solar cell in the present invention, the n-side transparent conductive oxide layer is formed after the p-side transparent conductive oxide layer has been formed.

### Effect of the Invention

The present invention is able to provide a manufacturing method for a solar cell having improved output characteristics.

### BRIEF DESCRIPTION OF THE DRAWINGS

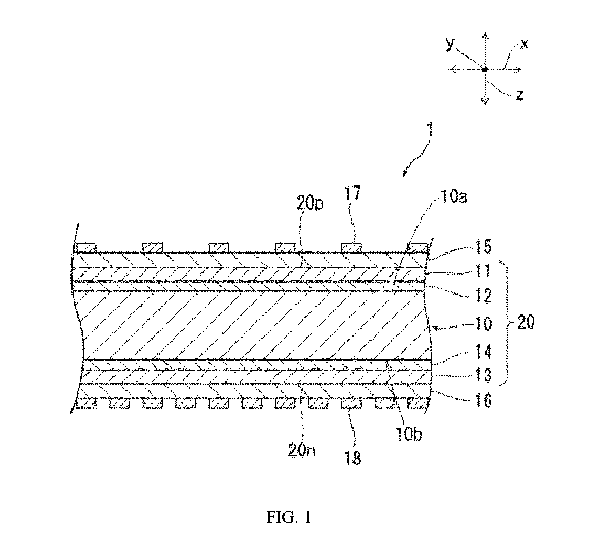

FIG. 1 is a cross-sectional view of a solar cell manufactured in an embodiment.

### DETAILED DESCRIPTION

The following is an explanation of an example of a preferred embodiment of the present invention. The following embodiment is merely an example. The present invention is not limited to the following embodiment in any way.

Further, in each of the drawings referenced in the embodiment, members having substantially the same function are denoted by the same symbols. The drawings referenced in the embodiment are also depicted schematically. The dimensional ratios of the objects depicted in the drawings may differ from those of the actual objects. The dimensional ratios of objects may also vary between drawings. The specific dimensional ratios of the objects should be determined with reference to the following explanation.

### Configuration of Solar Module 1

FIG. 1 is a cross-sectional view of a solar cell manufactured in an embodiment. First, the configuration of the solar cell manufactured in the embodiment will be explained with reference to FIG. 1.

The solar cell 1 is provided with a semiconductor substrate 10. The semiconductor substrate 10 can be a single-crystal semiconductor substrate or a polycrystalline semiconductor substrate. More specifically, the semiconductor substrate 10 can be a single-crystal silicon substrate.

In the explanation of present embodiment, the conductivity type of the semiconductor substrate 10 is n-type. However, the present invention is not limited to this. The conductivity type of the semiconductor substrate 10 can also be p-type.

A p-type semiconductor layer 11 with a different type of conductivity from the semiconductor substrate 10 is arranged on the first main surface 10a of the semiconductor substrate 10. The p-type semiconductor layer 11 can be made of a p-type amorphous silicon layer. The p-type semiconductor layer 11 preferably contains hydrogen. The thickness of the p-type semiconductor layer 11 can be from 3 nm to 20 nm, and is preferably from 5 nm to 15 nm. The amorphous silicon is a non-crystalline silicon semiconductor material containing fine crystalline silicon.

A substantially intrinsic semiconductor layer 12 is arranged between the first main surface 10a of the semiconductor substrate 10 and the p-type semiconductor layer 11. The substantially intrinsic semiconductor layer 12 can be an i-type amorphous silicon layer. The substantially intrinsic semiconductor layer 12 preferably contains hydrogen. The substantially intrinsic semiconductor layer 12 is preferably of a thickness that does not contribute substantially to the generation of electricity. The thickness of the substantially intrinsic semiconductor layer 12 can be from 3 nm to 15 nm, and is preferably from 5 nm to 10 nm.

An n-type semiconductor layer 13 with the same type of conductivity as the semiconductor substrate 10 is arranged on the second main surface 10b of the semiconductor substrate 10. The n-type semiconductor layer 13 can be made of an n-type amorphous silicon layer. The n-type semiconductor layer 13 preferably contains hydrogen. The thickness of the n-type semiconductor layer 13 can be from 3 nm to 25 nm, and is preferably from 5 nm to 15 nm.

A substantially intrinsic semiconductor layer 14 is arranged between the second main surface 10b of the semiconductor substrate 10 and the n-type semiconductor layer 13. The substantially intrinsic semiconductor layer 14 can be an i-type amorphous silicon layer. The substantially intrinsic semiconductor layer 14 is preferably of a thickness that does not contribute substantially to the generation of electricity. The substantially intrinsic semiconductor layer 14 preferably contains hydrogen. The thickness of the substantially intrinsic semiconductor layer 14 can be from 3 nm to 15 nm, and is preferably from 5 nm to 10 nm.

In the present invention, the photoelectric conversion unit 20 is composed of semiconductor layers 11-14 and semiconductor substrate 10. The photoelectric conversion unit 20 has a p-type surface 20p composed of the surface of the p-type semiconductor layer 11, and an n-type surface 20n composed of the surface of the n-type semiconductor layer 13.

A p-side transparent conductive oxide (TCO) layer 15 is arranged on the p-type surface 20p. A p-side collector electrode 17 is arranged on TCO layer 15. Holes are collected by the p-side collector electrode 17.

A n-side transparent conductive oxide (TCO) layer 16 is arranged on the n-type surface 20n. An n-side collector electrode 18 is arranged on TCO layer 16. Electrons are collected by the n-side collector electrode 18.

Specific examples of transparent conductive oxides that can be used as a constituent material in the TCO layers 15 and16 include indium oxide (In₂O₃), zinc oxide (ZnO), tin oxide (SnO₂), and cadmium stannate (Cd₂SnO₂). When indium oxide is used as a constituent material in the TCO layers 15 and 16, it may contain at least one of Sn, W, Ce, Ti, Nb and Zn. When zinc oxide is used, it may contain Al and/or Ga. When tin oxide is used, it may contain F.

### Manufacturing Method For Solar Cell 1

The following is an explanation on an example of the manufacturing method for a solar cell 1.

First, substantially intrinsic semiconductor layers 12 and 14are formed on the semiconductor substrate 10. Next, p-type semiconductor layer 11 is formed on substantially intrinsic semiconductor layer 12, and n-type semiconductor layer 13 is formed on substantially intrinsic semiconductor layer 14. These steps produce a photoelectric conversion unit 20.

The substantially intrinsic semiconductor layers 12 and 14, the p-type semiconductor layer 11, and the n-type semiconductor layer 13 can be formed using a deposition method such the sputtering method or a chemical vapor deposition (CVD).

Next, the p-side TCO layer 15 is formed. Afterwards, the n-side TCO layer 16 is formed. There are no particular restrictions on the method used to form the TCO layers 15 and 16. In addition to the CVD method, the TCO layers 15 and 16 can be formed using a physical vapor deposition (PVD) method such as the sputtering method, the ion plating method, the vacuum deposition method, or the electron beam deposition method. Among these examples, the TCO layers 15 and 16 are preferably formed using the ion plating method.

By using the ion plating method, the ion energy can be reduced to approximately 10 eV to 20 eV when the TCO layers 15 and 16 are formed on a p-type amorphous silicon layer. This significantly reduces the amount of ion energy as compared to a situation in which a transparent conductive film is formed using the sputtering method which entails ion energy of 100 eV or more. As a result, the amount of damage to the p-type semiconductor layer 11, the substantially intrinsic semiconductor layers 12 and 14and the semiconductor substrate 10 can be reduced.

When the TCO layers 15 and 16 are formed using the ion plating method, a target consisting of a sintered compact of In₂O₃ powder, containing from 1 mass% to 5 mass% of SnO₂ powder for doping, is placed in a position opposing the substrate inside a chamber to form the TCO layers 15 and 16. In this case, the amount of SnO₂ powder can be altered to change the amount of Sn in the ITO film constituting the TCO layers 15 and 16.

More specifically, the chamber is evacuated with the semiconductor substrate 10 arranged parallel to an opposing target in order to form the TCO layers 15 and 16. Afterwards, the pressure is held from 0.4 Pa to 1.0 Pa in a mixed gas flow of Ar and O₂, and the electrical discharge is initiated. After forming TCO layers 15 and 16 of ITO film to a thickness of approximately 100 nm, the electrical discharge is stopped.

The formation temperature for the p-side TCO layer 15 may be either identical to the formation temperature for the n-side TCO layer 16 or greater than the formation temperature for the n-side TCO layer 16.

The solar cell 1 can then be completed by forming the p-side collector electrode 17 and the n-side collector electrode 18. The collector electrodes 17 and 18 can be formed by applying a conductive paste or by using a plating method.

In the present embodiment, as explained above, the n-side TCO layer 16 is formed after the p-side TCO layer 15 has been formed. Therefore, a solar cell 1 with excellent output characteristics can be obtained. This is believed to be due to the following reason. The p-side TCO layer 15 is heated when the n-side TCO layer 16 is formed. This improves the ohmic properties between the p-type semiconductor layer 11 and the p-side TCO layer 15 because the crystallinity of the p-side TCO layer 15 is improved. As a result, the fill factor of the resulting solar cell is improved, and a solar cell 1 with excellent output characteristics is obtained.

In the explanation of the example of the embodiment, a p-type semiconductor layer 11 was formed on the first surface 10a of the semiconductor substrate 10, and an n-type semiconductor layer 13 was formed on the second main surface 10b. However, the present invention is not limited to this configuration. The solar cell in the present invention may also be a back contact solar cell provided with a photoelectric conversion unit having a p-type surface and an n-type surface on the same surface.

In the explanation of the example of the embodiment, the p-type surface was composed of a p-type semiconductor layer, and the n-type surface was composed of an n-type semiconductor layer. However, the present invention is not limited to this configuration. In the present invention, for example, the p-type surface may be composed of a p-type dopant diffusion region formed in the semiconductor substrate, and the n-type surface may be composed of an n-type dopant diffusion region formed in the semiconductor substrate.

In the explanation of the example of the embodiment, semiconductor layers 11-14 were formed, followed by the formation of the p-side TCO layer 15, and finally the formation of the n-side TCO layer 16. However, there are no particular restrictions on the formation of the layers in the present invention as long as the p-side TCO layer is formed before the n-side TCO layer. For example, an n-type semiconductor layer can be formed after the formation of the p-side TCO layer, followed by the formation of the n-side TCO layer.

The following is a more detailed explanation of the present invention with reference to a specific example of an embodiment. However, the present invention is in no way limited to the following example, and may be suitably altered and embodied within a range that does not alter the spirit of the invention.

### Example

A solar cell having a configuration substantially identical to the solar cell 1 in the first embodiment was manufactured using the method explained in the first embodiment under the following conditions. In other words, in the following example, the p-side TCO layer 15 is formed first, followed by formation of the n-side TCO layer 16.

Conditions of the Example:

### Formation Conditions for the TCO Layers 15 and 16:

Material of the TCO Layers 15 and 16: ITO 1 mass%
Gas Flow Rates: Argon Gas 300 sccm, Oxygen Gas 90 sccm
Input Power: 3 kW
Pressure: 0.6 Pa
Thickness of the TCO Layers 15 and 16: 100 nm

### Comparative Example

A solar cell was produced in the same manner as the example, except that in the comparative example the p-side TCO layer 15 was formed after the n-side TCO layer 16 has been formed.

The fill factor (F.F.) and the maximum output (Pmax) of the solar cells manufactured in the example and the comparative example were measured. The results are shown in Table 1 below. The values for the comparative example were normalized to 100 in Table 1.

**Table 1**

| | F.F. | Pmax |
|---|---|---|
| Example | 102 | 102 |
| Comparative Example | 100 | 100 |

It is clear from the results in Table 1 that the output characteristics of a solar cell can be improved by forming the n-side TCO layer 16 after the p-side TCO layer 15 has been formed.

### Key to the Drawings

1: Solar cell
10: Semiconductor substrate
10a: 1 st main surface
10b: 2nd main surface
11: p-type semiconductor layer
12, 14: Substantially intrinsic semiconductor layer
13: n-type semiconductor layer
15, 16: TCO layer
17: p-side collector electrode
18: n-side collector electrode
20: Photoelectric conversion unit

## Claims

1. A manufacturing method for a solar cell provided with a photoelectric conversion unit having a p-type surface and an n-type surface, a p-side transparent conductive oxide layer arranged on the p-type surface, an n-side transparent conductive oxide layer arranged on the n-type surface, a p-side electrode arranged on the p-side transparent conductive oxide layer, and an n-side electrode arranged on the n-side transparent conductive oxide layer;
the n-side transparent conductive oxide layer being formed after the p-side transparent conductive oxide layer has been formed.

2. The manufacturing method for a solar cell according to claim 1, wherein the p-side transparent conductive oxide layer is formed using a PVD method.

3. The manufacturing method for a solar cell according to claim 1 or claim 2,
wherein the photoelectric conversion unit has an n-type or p-type semiconductor substrate, a p-type semiconductor layer arranged on the semiconductor substrate and constituting the p-type surface, and an n-type semiconductor layer arranged on the semiconductor substrate and constituting the n-type surface.

4. The manufacturing method for a solar cell according to claim 3, wherein the p-type semiconductor layer is made of amorphous silicon.

5. The manufacturing method for a solar cell according to any of claims 1 through 4, wherein the p-side transparent conductive oxide layer is made of an indium oxide-based material or a zinc oxide-based material.
